Europäisches Patentamt

European Patent Office

Office européen des brevets

(19)

(11) Publication number: **0 431 261 A1**

(12) **EUROPEAN PATENT APPLICATION**

(21) Application number: **90115893.1**

(22) Date of filing: **20.08.90**

(51) Int. Cl.5: **H01L 23/04**, H01L 23/06,
H01L 23/14, H01L 21/52

The title of the invention has been amended (Guidelines for Examination in the EPO, A-III, 7.3).

(30) Priority: **07.12.89 US 448780**

(43) Date of publication of application:
**12.06.91 Bulletin 91/24**

(84) Designated Contracting States:
**DE FR GB IT**

(71) Applicant: **International Business Machines Corporation**
**Old Orchard Road**
**Armonk, N.Y. 10504(US)**

(72) Inventor: **Bregman, Mark Fielding**

**63 Old Washington Road**
**Ridgefield, Connecticut 06877(US)**
Inventor: **Horton, Robert Raymond**
**106 Ridge Road**
**Dover Plains, New York 12522(US)**
Inventor: **Noyan, Ismail Cevdet**
**1235 Main Street**
**Peekskill, New York 10566(US)**
Inventor: **Palmer, Michael Jon**
**Rd. 2, Box 372**
**Walden, New York 12586(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

(54) **Integrated circuit package with cap and device of the same material.**

(57) A thermally matched integrated circuit package comprising a semiconductor substrate; at least one semiconductor electronic device mounted on said substrate; means for providing electrical connections to said at least one semiconductor electronic device and to said substrate; and a semiconductor cap, disposed over said at least one device, wherein the cap is directly attached to said substrate and further wherein said substrate, said at least one device, and said cap are all formed from the same semiconductor material to assure no thermal mismatch therebetween. The cap comprises at least one cavity which is disposed over at least one semiconductor electronic device. The cap may be fabricated utilizing anisotropic etching techniques or via electrodischarge machining. Hermetically sealed and nonhermetically sealed caps are both contemplated, as well as a grooved cap having an increased surface area to enhance its inherent cooling capacity. The invention is well suited to enhancing the performance of large scale multichip carrier modules.

FIG. 1

EP 0 431 261 A1

# THERMALLY MATCHED INTEGRATED CIRCUIT PACKAGE

The invention relates generally to integrated circuit (IC) packages and to IC package fabrication techniques. More particularly, the invention relates to an IC package that includes a cap, directly attached to a substrate having at least one active chip mounted thereon.

Packaging is increasingly the limiting factor in achieving maximum performance from Very Large Scale Integrated (VLSI) based computer systems. The limitations due to packaging arise from two major physical constraints; the maximum power density that can be cooled and the signal transit delay introduced by the package.

Conventional packaging techniques address these concerns. Typically, a package consists of a silicon planar having discrete wiring terminated in standard metallurgy. The planar may be joined to logic and memory chips using, for example, a C4 (solder ball) joining scheme. By the very nature of a silicon on silicon package, a major source of concern is eliminated; thermal mismatches between the chip and substrate.

The the prior art is replete with packaging schemes that improve on the basic concept of a silicon on silicon package and address the aforementioned physical constraints. For example, Glascock, II et al, U.S. Patent No. 4,745,455 describes a hermetically sealed package for a power semiconductor wafer. The package comprises substantially entirely silicon materials selected to have coefficients of thermal expansion closely matching that of the silicon power wafer. The wafer comprises a layer of silicon material having first and second device regions on respective sides thereof. An electrically conductive cap and base, each including a layer of silicon material, are disposed in electrical contact with the first and second regions of the semiconductor respectively. An electrically insulative sidewall of silicon material surrounds the wafer, is spaced from an edge thereof, and is bonded to the cap and base for hermetically sealing the package.

Although the Glascock, II et al package addresses thermal matching, the package requires an electrical passivant to prevent electrical breakdown between the aforementioned cap and base. An arc suppressant is also required to be disposed within the package to prevent electrical arcing between the cap and base.

Furthermore, the Glascock, II et al package is designed to house a single semiconductor component, e.g., a power semiconductor, and does not address packaging multichip carriers typically used in state of the art VLSI systems.

Another example of prior art attempts to address the aforementioned physical constraints is Ng et al, U.S. patent No. 4,613,891. Ng et al describes a packaging scheme for one or more silicon integrated circuit chips which are mounted active side up to the bottom of a silicon wafer. A sloped-wall through-aperture is wet etched in the substrate corresponding to and in registry with a portion of the active side of each attached chip. Electrically connection is made to the chips by conductive patterns on the sloped walls.

The Ng et al package typifies attempts to address the signal transit time constraint by densly packing chips in a single package.

Further examples of prior and related art schemes for providing high density packing of integrated circuit chips, various degrees of thermal matching of package components, various types of package seals, related etching techniques, etc. can be found in Kendell et al, U.S. Patent No. 3,936,329; Spears et al, U.S. Patent No. 3,742,230; Reed et al, U.S. Patent No. 4,781,775; Tustaniwskyi, U.S. Patent No. 4,807,019; Mikkor, U.S. Patent No. 4,701,424; Chatterjee, U.S. Patent No. 4,695,872; Tai, U.S. Patent No. 4,670,770 and McPherson, U.S. Patent No. 4,650,922.

The technical literature is also replete with teachings of chip carriers and packaging techniques which attempt to solve the aforementioned physical constraints. For example, IBM Technical Disclousre Bulletin Volume 15, Number 2, dated July, 1972, describes a relatively early attempt to address physical density constraints using a structure in which semiconductor chips containing active and passive devices are mounted on semiconductor carrier substrates also containing active and passive devices.

A further example of the prior art is set forth in IBM Technical Disclosure Bulletin Volume 23, Number 7A, dated December, 1980, which describes packaging for multichip modules. Here, a plurality of silicon chips are mounted onto a silicon substrate in a flip-chip configuration. The process taught in this reference comprehends joining of predicted LSI chips to a large personalization chip (or wafer) via ball-limiting metallurgy. The silicon substrate is in turn mounted onto a ceramic module substrate with module pins.

Yet another example of the prior art is described in IBM Technical Bulletin Volume 17, Number 3, dated August, 1974 in which a silicon on silicon plastic duel in-line module is taught. The module utilizes a silicon intermediate layer positioned between the wiring of the package and the silicon chip to improve module reliability by reducing the stress on the bonding pads associated with the chip.

The invention as claimed is intended to remedy these drawbacks. It solves the problem of how to provide an IC chip package which exhibits a complete thermal matching between chip(s), substrate and cap to thereby enhance the performance of the packaged system.

According to the invention, the desired structure comprises the combination of a semiconductor substrate; at least one semiconductor electronic device mounted on said substrate; means for providing electrical connections to said at least one semiconductor electronic device and said substrate; and a semiconductor cap, disposed over said at least one device, wherein said cap is directly attached to said substrate and further wherein said substrate, said at least one device, and said cap are all formed from the same semiconductor material to assure no thermal mismatch therebetween.

The aforementioned cap comprises at least one cavity which is disposed over at least one semiconductor electronic device. The cap may be fabricated utilizing anisotropic etching techniques or via electro-discharge machining. Hermetically sealed and nonhermetically sealed caps are both contemplated, as well as a grooved cap having an increased surface area to enhance its inherent cooling capacity.

According to an illustrative embodiment of the invention, the structure comprises at least one silicon integrated circuit chip mounted in electrical connection onto a silicon substrate. The aforementioned chip is (or chips are) mounted in a flip-chip configuration onto the substrate, being electrically connected thereto via a plurality of solder balls. A hermetic or nonhermetic cap, also formed of silicon, is placed over the chip(s) and is directly attached to the substrate. The substrate can be electrically connected to devices outside the package via exposed layers of the substrate that are not encapsulated within the package.

According to another embodiment of the invention a photomasking technique can be utilized to improve the caps cooling capacity by causing grooves to be etched in the cap to increase its cooling surface area.

The invention features an I/C package and packaging techniques which are particulary well suited for packaging large scale multichip carrier modules. The package contemplated by the invention assures that no thermal mismatch exists between the planar and sealed cap. Further features of the invention include a packaging technique that does not require the use of an electrical passivant or arc suppressant.

Despite all of the advances in chip packaging as exemplified by the above referenced patents and literature, no IC package or packaging techniques are known which extend the concept of avoiding thermal mismatch between the chip and substrate (by utilizing the same semiconductor for these component) to include a hermetic or nonhermetic sealed cap made of the same material as the substrate and chip (or chips). Such an arrangement permits the direct attachment of the cap to the substrate without having to be concerned about thermal mismatch. The sealed cap in such an arrangement is able to very effectively remove heat from the package if made of an appropriate material, e.g., silicon, GaAs, or Ge semiconductors.

Further yet, the IC package, preferably containing a multichip carrier used in VLSI based systems, exhibits the above described matched thermal characteristics without requiring the use of an electrical passivant or arc suppressant.

Further, the package exhibits the aforementioned matched thermal characteristics and the manufacturing tolerances for the package can be accurately controlled and maintained. Additionally, the aforementioned characteristics are exhibited and the use of an electrical passivant and/or arc suppressant is not required.

These and other objects and features of the present invention and the manner of obtaining them, and the invention itself will be best understood by reference to the following detailed description read in conjunction with the accompanying drawings, in which:

FIG. 1 depicts a cap having nine individual cavities to seal nine chips, where the cap is structured and may be fabricated, in accordance with the teachings of the invention; and

FIG. 2 depicts a cap having the same outer dimensions as the cap depicted in FIG. 1, however the cap depicted in FIG. 2 is an alternate embodiment of the invention in which a plurality of chips can be located within a common cavity under the cap.

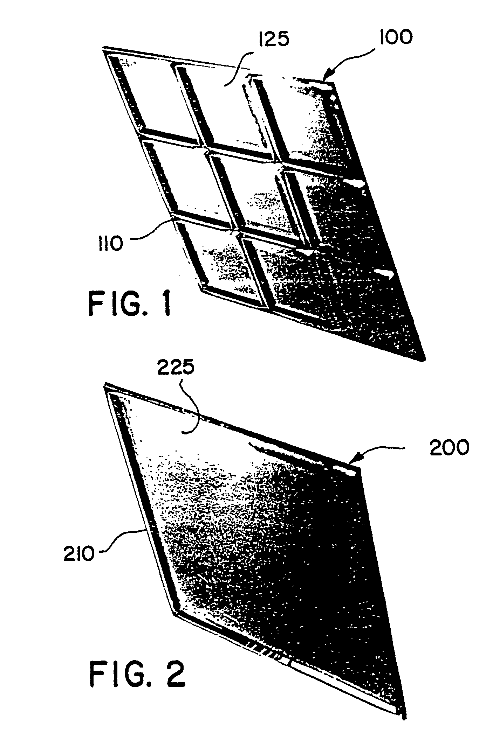

Two caps having the same outer dimensions, structured and fabricated in accordance with the teachings of the invention, are depicted in the photographs reproduced as FIGs. 1 and 2 herein. FIG. 1 depicts an illustrative embodiment of the invention consisting of a silicon cap having nine individual cavities. Each cavity of the illustrative cap is designed to seal a chip. FIG. 2 depicts an alternate illustrative embodiment of the invention in which a plurality of chips can be located within a common cavity under the depicted cap (also made of silicon).

Industry standard anisotropic etching techniques can be employed to fabricate the silicon caps depicted in FIGs. 1 and 2. A preferred base to etch the silicon is a catalyzed ethylene diamine-pyrocatechol and water solution.

Alternatively, if the correct doping levels are present in the silicon, it is possible to create the cavity or cavities depicted in FIGs. 1 and 2 by electro-discharge machining. In this case the doped material must be conductive enough to support a spark.

The illustrative caps depicted in FIGs. 1 and 2 were fabricated from silicon wafers having an orientation of (100) and a thickness of 1.27 mm (.050 inches). The wafers were thermally oxidized and photoprocessed to open windows in the oxide to act as an etch barrier during cavity etch.

Illustrative cap 100 depicted in FIG. 1 is shown as having a 0.254 mm (.010 inch) groove, 110, etched around the periphery of nine 0.635 mm (.025 inch) deep cavities, such as cavity 125. Illustrative cap 200 depicted in FIG. 2 is shown as having a similar 0.254 mm (.010 inch) groove, 210, etched around the periphery of a single 0.635 mm (.025 inch) cavity, 225. The groove and cavity depths indicated are for the sake of illustration only and are not meant to in any way limit the scope of the invention.

According to one embodiment of the invention, the grooves can be etched to serve as a reservoir for a sealant in a nonhermetic package. This area would not be etched in a hermetic version but instead would have appropriate metallurgy, e.g., a combination of chrome, copper and gold, to support a solder seal.

After being etched to a preselected depth, the wafer can be diced using standard wafer dicing techniques, to a proscribed dimension to coincide with the planar package.

Where a flip-chip configuration is used to mount the chips on the substrate, the cavity depth can be designed so that the enclosed portion of the cap is flush with the chip surface to form a very compact package In cases where it is not desirable to have the cap flush with the chip surface, such as when the active side of the chip would otherwise abutt the cap, the cavities can be designed to be slightly deeper to make the cap slightly higher than the top of the chip(s) being covered.

An alternate embodiment of the invention could employ a photomasking technique to produce the aforementioned cavities and provide openings on the reverse side of the silicon wafer to form grooves to increase the surface area on the back of the cap. This increased surface area would then provide increased cooling capacity, especially in the hermetic version of the cap.

The etching to produce both the aforementioned cavity and/or cavities and grooves, can be performed simultaneously, i.e., no additional processing is required to fabricate the grooved cap.

The processes described herein can be used to fabricate caps having a variety of thickness simply by varying the consistency of the base described hereinbefore. Close manufacturing tolerances can be maintained when using the above described photoprocess to fabricate the caps.

It should be noted that no electrical passivant or arc suppressant is required since the cap has no potential difference between itself, the substrate and any chip(s) mounted on the substrate.

Although described with reference to a silicon on silicon package having a silicon cap, the invention contemplates packages formed from any desired semiconductor material, eg. GaAs, Ge, etc., so long as the cap, chip(s) and substrate are all fabricated from the same material.

Means other then solder balls are also contemplated by the inventor as means for providing electrical connections between the substrate and chips mounted thereon. For example, discrete wiring could be used as in wire bonding.

## Claims

1. A thermally matched integrated circuit package, comprising:
    (a) a semiconductor substrate;
    (b) at least one semiconductor electronic device mounted on said substrate;
    (c) means for providing electrical connections to said at least one semiconductor electronic device and to said substrate; and
    (d) a semiconductor cap, disposed over said at least one device, wherein at least a portion of said cap is directly attached to said substrate and further wherein said substrate, said at least one device, and said cap are all formed from the same semiconductor material to assure no thermal mismatch therebetween.

2. Package as set forth in claim 1 wherein said cap comprising at least one cavity which can be disposed over at least one semiconductor electronic device, preferably said cavity is formed by the anisotropic etching or by electro-discharge machining of a semiconductor wafer.

3. Package as set forth in claim 2 wherein said cap further comprises grooves to facilitate the formation of a hermetic seal between said cap and said substrate.

4. Package as set forth in claim 2 wherein said cap further comprises grooves to serve as a sealant reservoir to facilitate the formation of a nonhermetic seal between said cap and said substrate.

5. Package as set forth in claim 3 or 4 wherein a nonhermetic or a hermetic seal, respectively, is formed between said cap and said substrate.

6. Package as set forth in any one of the preceding claims 2 to 5 wherein said cap further comprises a grooved formation on the exterior of said cap which increases cap surface area for dissipating heat.

7. Package as set forth in any one of the preceding claims wherein said semiconductor material consisting essentially of silicon or of GaAs or of Ge.

8. Package as set forth in any one of the preceding claims wherein said semiconductor cap is indirectly attached to said substrate via means disposed between said cap and said substrate, wherein said substrate, said at least one device, said cap and said means disposed between said cap and said substrate, are all formed from the same semiconductor material to assure no thermal mismatch therebetween.

9. Package as set forth in claim 8 wherein said means disposed between said cap and said substrate is a semiconductor ring.

10. A method for fabricating a thermally matched integrated circuit package, comprising the steps of:

(a) fabricating a semiconductor substrate, at least one semiconductor electronic device and a cap for said package, wherein said substrate, each electronic device and said cap are all formed from the same semiconductor material to assure no thermal mismatch therebetween;
(b) mounting each device on said substrate;
(c) forming electrical connections to said at least one semiconductor electronic device and to said substrate;
(d) disposing said cap over said at least one device; and
(e) directly attaching said cap to said substrate.

11. A method as set forth in claim 10 wherein fabricating said cap, comprises the steps of:
(a) selecting a semiconductor wafer from which to form the cap where the semiconductor wafer is fabricated from the same material utilized to form said substrate and each electronic device;

(b) creating at least one cavity in said wafer having a sufficient depth to encapsulate at least one semiconductor device.

12. A method as set forth in claim 11 wherein said step of creating at least one cavity in said wafer further comprises the steps of:
(a) oxidizing said semiconductor wafer;
(b) photoprocessing the oxidized wafer to open windows in the oxide to act as an etch barrier; and
(c) etching said wafer, utilizing anisotropic etching techniques.

13. A method as set forth in claim 11 wherein the step of creating at least one cavity in said wafer further comprising the steps of:
(a) doping said wafer to assure that the wafer is conductive enough to support a spark; and
(b) creating said at least one cavity in said wafer utilizing electro-discharge machining techniques.

14. A method as set forth in claim 12 or 13 further comprising the step of dicing said wafer to a preselected dimension so that the cap resulting from the preselected dimension so that the cap resulting from the dicing process coincides with said substrate facilitating direct attachment of the cap thereto.

15. A method as set forth in any one of the preceding claims 11 to 14 further comprising the step of forming means on said cap to facilitate hermetically sealing said cap and said substrate.

16. A method as set forth in claim 15 further comprising the step of hermetically sealing said cap to said substrate.

17. A method as set forth in any one of the preceding claims 11 to 14 further comprising the step of forming means to serve as a sealant reservoir to facilitate a nonhermetic seal between said cap and said substrate.

18. A method as set forth in claim 17 further comprising the step of providing a nonhermetic seal between said cap and said substrate.

19. A method as set forth in claim 11 further comprising the step of forming means for dissipating heat on the exterior of said cap.

20. A method as set forth in claim 19 wherein said step of forming means for dissipating heat comprises the step of increasing cap surface area.

21. A method as set forth in claim 19 wherein said means for dissipating heat and said at least one cavity are formed simultaneously utilizing a combination photomasking anisotropic etching process.

FIG. 1

FIG. 2

European
Patent Office

# EUROPEAN SEARCH REPORT

Application Number

EP 90 11 5893

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 760 440 (R.R.BIGLER ET AL.) <br> * column 2, line 8 - column 3, line 35; figure 2 * | 1,7,10 | H 01 L 23/04 <br> H 01 L 23/06 <br> H 01 L 23/14 |
| Y,A | EP-A-0 331 245 (LSI LOGIC CORPORATION) <br> * column 4, line 1 - column 6, line 2; figures 1-8 ** ditto * | 1,2,7-11, 15,16,12, 14 | H 01 L 21/52 |
| Y | EP-A-0 244 767 (GENERAL ELECTRIC COMPANY) <br> * page 8, line 29 - page 11, line 21; figure 1 * | 1,2,7-11, 15,16 | |
| A | PATENT ABSTRACTS OF JAPAN vol. 9, no. 140 <br> (E-321)(1863) 14 June 1985, <br> & JP-A-60 021544 (HITACHI OUME DENSHI) 02 February 1985, <br> * the whole document * | 3 | |
| A | EP-A-0 174 020 (GTE PRODUCTS CORPORATION) <br> * page 1, line 23 - page 2, line 9 ** page 3, line 20 - page 4, line 25; figures 1-6 * | 6,19,20 | |
| D,A | US-A-3 936 329 (D.L.KENDALL ET AL.) <br> * column 2, lines 46 - 67; figures 1a-1e * | 12,21 | TECHNICAL FIELDS SEARCHED (Int. Cl.5) |
| A | IBM TECHNICAL DISCLOSURE BULLETIN vol. 20, no. 10, March 1978, NEW YORK , USA pages 3903 - 3905; S.MAGDO: "SEMICONDUCTOR ENCAPSULATION" <br> * the whole document * | 1,8,10,15, 16 | H 01 L |

The present search report has been drawn up for all claims

| Place of search | Date of completion of search | Examiner |
|---|---|---|
| Berlin | 05 March 91 | LE MINH I |

CATEGORY OF CITED DOCUMENTS

X : particularly relevant if taken alone
Y : particularly relevant if combined with another
      document of the same catagory
A : technological background
O : non-written disclosure
P : intermediate document
T : theory or principle underlying the invention

E : earlier patent document, but published on, or after
      the filing date
D : document cited in the application
L : document cited for other reasons

& : member of the same patent family, corresponding
      document